(19) Europäisches Patentamt
European Patent Office
Office européen des brevets

(11) **EP 3 948 945 B1**

(12) **EUROPEAN PATENT SPECIFICATION**

(45) Date of publication and mention
of the grant of the patent:
**27.05.2026 Bulletin 2026/22**

(21) Application number: **19722776.2**

(22) Date of filing: **28.03.2019**

(51) International Patent Classification (IPC):
*H10W 40/70* *(2026.01)*        *H10W 40/73* *(2026.01)*
*H10W 40/77* *(2026.01)*

(52) Cooperative Patent Classification (CPC):
**H10W 40/70; H10W 40/73; H10W 40/778**

(86) International application number:
**PCT/BY2019/000002**

(87) International publication number:
**WO 2020/191473 (01.10.2020 Gazette 2020/40)**

(54) **HEAT TRANSFER STRUCTURE AND ELECTRONIC ASSEMBLY COMPRISING SUCH A HEAT TRANSFER STRUCTURE**

WÄRMEÜBERTRAGUNGSSTRUKTUR UND ELEKTRONISCHE ANORDNUNG MIT SOLCH EINER WÄRMEÜBERTRAGUNGSSTRUKTUR

STRUCTURE DE TRANSFERT DE CHALEUR ET ENSEMBLE ÉLECTRONIQUE COMPRENANT UNE TELLE STRUCTURE DE TRANSFERT DE CHALEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**09.02.2022 Bulletin 2022/06**

(73) Proprietor: **Huawei Technologies Co., Ltd.**
**Shenzhen, Guangdong 518129 (CN)**

(72) Inventor: **TANG, Yun**
**Shenzhen, Guangdong 518129 (CN)**

(74) Representative: **Roth, Sebastian**
**Mitscherlich PartmbB**
**Karlstraße 7**
**80333 München (DE)**

(56) References cited:
**US-A- 5 944 093          US-A1- 2004 052 052**
**US-A1- 2006 139 887          US-A1- 2007 146 996**
**US-A1- 2008 053 640          US-A1- 2008 105 404**
**US-A1- 2017 038 154**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a heat transfer structure for transferring heat generated by an electronic device to a heat sink. Further, the present invention relates to an electronic assembly comprising an electronic device, a heat sink, and such a heat transfer structure.

BACKGROUND

A heat source like an electronic device in service, e.g. a chip or a micro-processor, generates heat that has to be transferred to a heat sink where the heat can be dissipated to the ambient. However, the distance separating the heat source and the heat sink cannot be fixed precisely due to manufacturing and assembly tolerances of the electronic device and/or of the heat sink. In particular, the overall thickness of the heat source and the depth of the recess in the heat sink where the heat source is arranged may vary from one electronic assembly to the other. For example, the difference of one electronic device to another may be up to 0.6 mm, but this difference is usually known only after the heat source and the heat sink have been assembled together. Hence, one cannot accurately define the final thickness required for a heat transfer structure intended to thermally connect the heat source and the heat sink.

Sometimes, the gap remaining between the heat source and the heat sink due to the manufacturing and assembly tolerances is filled with a layer of a thermal interface material, for example a gel layer. But the gel layer has a relatively low thermal conductivity and a relatively large thickness or, correspondingly, a high thermal resistance, which diminishes the efficiency in the heat transfer.

Document US 2004/0052052 A1 discloses a circuit device cooling apparatus and method. The apparatus has a first heat pipe which includes a first heat pipe condenser, and a second heat pipe which includes a second heat pipe condenser. A heat sink is attached to the first heat pipe condenser and the second heat pipe condenser.

Document US 2008/0053640A1 discloses methods and arrangements for cooling a semiconductor chip. A first method resides in locating a vapor chamber with a compliant surface facing the chip, which is located underneath the chamber. A second method positions a chip inside a semiconductor vapor chamber that possesses compliant chamber walls.

Document US 2007/0146996 A1 discloses an apparatus and system for cooling of heat producing components. The apparatus includes a mounting plate rigidly connected with a top surface of a circuit board and positioned above a heat producing circuit board component, a heat sink having first and second ends, and at least one bellows device coupling a heat transfer tip with the first end of the heat sink. The system includes a circuit board, a plurality of heat producing circuit board components, and the described apparatus.

Document US 2017/0038154 A1 discloses a vapor chamber structure including a plate-shaped shell and at least one stretchable heated member. The plate-shaped shell has a hollow interior to form a cavity and has a base on which at least one throughhole is disposed that communicates with the cavity. The stretchable heated member includes a heated plate and a hollow stretchable tube. The heated plate is sealedly connected to one end of the stretchable tube and the throughhole of the plate-shaped shell is sealedly connected to the other end of the stretchable tube.

SUMMARY

In view of the above-mentioned problems and disadvantages, embodiments of the present invention aim to improve the current implementations. An objective is to provide a heat transfer structure, which may efficiently transfer heat and which may self-adapt its thickness to the final distance actually separating a heat source and a heat sink in an electronic assembly.

The objective is achieved by the embodiment of the invention as described in the enclosed independent claim. Advantageous implementations of the present invention are further defined in the dependent claims. In the following, parts of the description and drawings referring to embodiments not covered by the claims, are not part of the invention, but are illustrative examples necessary for understanding the invention.

An aspect of the invention provides a heat transfer structure, for transferring heat generated by an electronic device to a heat sink, the heat transfer structure comprising a housing defining a chamber and containing an evaporative liquid, wherein the housing comprises i) a first part which provides a heat-receiving outer surface for being thermally connected to the electronic device and ii) a second part which provides a heat-emitting outer surface for being thermally connected to the heat sink, and iii) a circumferential part arranged between the first part and the second part, wherein the circumferential part is plastically or elastically deformable to allow for a displacement of the heat-emitting outer surface relative to the heat-receiving outer surface , and iv) a porous structure arranged within the housing and partly or totally in direct contact with the first part, wherein the porous structure comprises a porous deformable part which extends between the first part and the second part, and wherein the porous deformable part includes one or more flexible arms, the at least one flexible arm being arranged around the heat-receiving outer surface.

As the circumferential part is deformable the housing may be compressed by application of external forces during an assembling step in accordance with the actual distance separating the heat source and the heat sink. Thus, the heat transfer structure allows to compensate for the manufacturing and assembly tolerances after the heat transfer structure is installed in an electronic assembly. Therefore, a conventional thick gel layer may be replaced by a thin layer of thermal interface material spread onto the corresponding surfaces of the heat source and of the heat sink in order to enhance thermal connection with the electronic assembly units, thus keeping the thermal resistance low.

In a particular implementation form, the housing may hermetically contain the evaporative liquid inside the chamber. In an initial step for manufacturing the chamber is vacuumed and then filled with a proper amount of evaporative liquid. In a particular implementation form, the housing may present a symmetry of revolution, having for example a cylindrical or frustoconical shape.

In a particular implementation form, the heat transfer structure may define a so-called "vapor chamber", where the heat transfer structure may include a housing formed by walls, a porous structure formed by a wick, a working fluid and a support as the case may be.

The evaporative liquid may be a two-phase working fluid (vapor phase and liquid phase). In particular, the evaporative liquid may be water or any other vaporizing liquid. When the heat transfer structure is in service the evaporative liquid may evaporate when the heat-receiving outer surface receives heat from the heat source, i.e. from the electronic device. Evaporation of the evaporative liquid occurs on an evaporation side of the housing. The vapor of evaporative liquid may flow through the chamber and toward the heat-emitting outer surface. The vapor of evaporative liquid may condense when the heat-emitting outer surface emits heat and may hence dissipate the heat in the ambient. Condensation of the evaporative liquid occurs inside the chamber at the condensation side of the housing. The condensed evaporative liquid may flow through the housing and toward the heat-receiving outer surface.

in case the circumferential part is elastically deformable the housing may be decompressed, hence expanded, after release of the external forces applied thereon. The evaporative liquid in the chamber may help in decompressing the housing due to its vapor pressure acting inside the housing.

In an implementation form of the aspect, the circumferential part includes a corrugated or bellow-shaped membrane, the corrugated or bellow-shaped membrane being elastically deformable.

In a particular implementation form. the corrugated membrane or the below-shaped membrane may be formed by a membrane having alternating peaks and troughs. The corrugated membrane or the below-shaped membrane may have a wavy profile, for example a sine wave profile or a triangular wave profile.

In an implementation form of the aspect, the circumferential part has an annular shape or a cylindrical shape.

Thus, deformation of the circumferential part may be distributed, for example uniformly distributed, around an axis of revolution of the annular shape or of the cylindrical shape.

In an implementation form of the aspect, the circumferential part includes a toroidal membrane, the toroidal membrane defining the shape of a half of a toroid and being plastically deformable.

Thus, the toroidal membrane may allow compression of the housing when external forces or inner pressure is applied. Plastic deformation may take place in the toroidal membrane due its material properties and/or to its wall thickness.

In an implementation form of the aspect, at least one of the heat-receiving outer surface and the heat-emitting outer surface is flat.

Thus, a flat heat-receiving outer surface may define a large contact area for receiving heat from the heat source. i.e. from the electronic device. Likewise, a flat heat-emitting outer surface may define a large contact area for emitting heat to the heat sink.

In a particular implementation form, the heat-receiving outer surface and the heat-emitting outer surface may be parallel to each other. In a particular implementation form, the first part and/or the second part may be plate-shaped or disc-shaped. In a particular implementation form, the area of the heat-receiving outer surface and the area of the heat-emitting outer surface may be substantially equal. Further, the area of the heat-receiving outer surface may be configured to maximally cover a facing area of the heat source.

In an implementation form of the aspect, the circumferential part includes at least one of i) a first deformable portion extending around the heat-receiving outer surface and ii) a second deformable portion extending around the heat-emitting outer surface.

Thus, such a first deformable portion and/or such a second deformable portion may contribute to the deformation of the circumferential part.

In an implementation form of the aspect, no structural element is arranged inside the housing.

Thus, the housing may provide for a larger compression distance than in background art structures due to absence of structural elements inside the gap, since no structural element bridges the first part and the second part.

When the pressure inside the housing is high it generates relatively large external forces acting on the outer surfaces of the housing, in particular on the heat-receiving and heat-emitting outer surfaces. Such external forces in turn improve contact, hence heat transfer, between the heat-receiving surface and the heat source and/or between the heat-emitting surface and the heat sink.

The heat transfer structure further comprises a porous structure arranged within the housing and partly or totally in direct contact with the first part.

Such a porous structure, i.e. a wick structure, creates capillary forces to move the condensed evaporative liquid toward the second part, hence toward the heat-receiving outer surface. So the evaporative liquid flows back toward the evaporation side of the housing. Besides, such a porous structure enhances the evaporation efficiency. In a particular implementation form, the porous structure may be clad onto the first part. Further, the porous structure may be clad onto the second part. Further, the porous structure may be clad onto the circumferential part. The porous structure may form a layer that covers at least portions of the first part, of the second part and/or of the circumferential part. In a particular implementation form, at least a portion of the porous structure is clad on the second part of the housing. This portion may be formed as a layer.

In an implementation form of the aspect, at least a portion of the porous structure may be in direct contact with the second part.

Thus, such a porous structure may create capillary forces for spreading the evaporative liquid along the first part, eventually toward the evaporation side of the housing and near the heat-receiving outer surface. So the evaporative liquid may flow back to the evaporation side of the housing.

The porous structure comprises a porous deformable part which extends between the first part and the second part.

Such a porous deformable part follows the deformation of the circumferential part when the housing is compressed or decompressed.

The porous structure is plastically or elastically deformable. In particular, the porous deformable part may be selected in the group consisting of: a single-layer of metal mesh, several layers of metal mesh, a single fiber braided metal threads, several fibers of braided metal threads, a single layer of metal felt, several layers of metal felt, and any combination thereof.

In a particular implementation form, the porous deformable part includes a wick configured to create capillary forces so as to absorb evaporative liquid at the condensation side of the housing, and to transport condensed evaporative liquid toward the evaporation side of the housing.

In a particular implementation form, the porous structure may include a rigid porous body that may be arranged in contact with at least a portion of the first part. The rigid porous body may be formed by a sintered metal powder or by a single layer of metal mesh or by several layers of metal mesh.. The porous structure may extend from the first part (evaporation side of the housing) to the second part (condensation side of the housing).

The porous deformable part includes one or more flexible arms, the at least one flexible arm being arranged around the heat-receiving outer surface.

Such flexible arm allows the porous deformable part to deform elastically or plastically.

In an implementation form of the aspect, the heat transfer structure further comprises a flexible support extending i) between the first part and the second part and ii) partially around the heat-receiving outer surface.

Thus, such a flexible support may allow the housing to deform elastically, the flexible support itself being deformed plastically or elastically. The flexible support may comprise a leaf spring.

In an implementation form of the aspect, the porous structure is joined to the housing by laser welding. Besides, a method for assembling a heat transfer structure of the aspect includes the steps of: i) placing the porous structure next to the housing, and ii) joining the porous structure to the housing by laser welding.

In an implementation form of the aspect, an electronic assembly comprises an electronic device, a heat sink, and a heat transfer structure of any one of the preceding claims, wherein the first part of the housing is in thermal contact with the electronic device and the second part is in thermal contact with the heat sink.

The electronic device comprises at least one electronic component that generates heat when functioning. The electronic device may comprise several electronic components. The heat sink comprises at least one heat dissipating element that dissipates heat in the ambient or surrounding environment. In a particular implementation form, the heat sink may comprise several heat dissipating elements.

In a particular implementation form, the electronic assembly may further comprise i) a first thin layer of a thermal interface material, e.g. a thermal grease, arranged between the housing and the heat source, and/or ii) a second thin layer of a thermal interface material, e.g. a thermal grease, arranged between the housing and the heat sink. Such thin layers of thermal interface material induce a smaller thermal resistance as compared to thick gel layers as implemented in background art structures.

When the electronic assembly is in service a thermal contact between the heat-receiving outer surface and the electronic device may result from a direct contact between the heat-receiving outer surface and the electronic device, this direct contact possibly arising through a thin layer of thermal interface material. Alternatively, such thermal contact may result from an indirect contact, wherein it involves at least one intermediary component, which is arranged between the heat-receiving outer surface and the electronic device.

When the electronic assembly is in service a thermal contact between the heat-emitting outer surface and the heat sink may result from a direct contact between the heat-emitting outer surface and the heat sink, this direct contact possibly arising through a thin layer of thermal interface material. Alternatively, such thermal contact may result from an indirect contact, wherein it involves at least one intermediary element or substance, which is arranged between the heat-emitting outer surface and the heat sink.

It has to be noted that all devices, elements, units and means described in the present application could be implemented in any technically applicable combination of the implementation forms. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in any technically applicable combination of the implementation forms.

BRIEF DESCRIPTION OF DRAWINGS

The above described aspects and implementation forms of the present invention will be explained in the following description of specific embodiments and aspects in relation to the enclosed drawings, in which

FIG. 1    is a schematic perspective view illustrating an electronic assembly according to an embodiment and comprising a heat transfer structure according to a first aspect.

FIG. 2    is a schematic perspective view, at an angle different from figure 1, illustrating the heat transfer structure of figure 1.

FIG. 3    is a schematic cross-sectional view, along a median plane III on figure 2, illustrating the heat transfer structure of figure 1.

FIG. 4    is a view similar to figure 3 illustrating a heat transfer structure according to a second aspect.

FIG. 5    is a schematic perspective view illustrating a heat transfer structure according to a third aspect.

FIG. 6    is a cross-sectional view, along a median plane VI on figure 5.

FIG. 7    is a schematic perspective view illustrating a heat transfer structure according to a fourth aspect.

FIG. 8    is a view similar to figure 3 cross-sectional view, along a median plane VIII on figure 6.

FIG. 9    is a view similar to figure 3 illustrating a heat transfer structure according to a fifth aspect.

FIG. 10    is a view similar to figure 3 illustrating a heat transfer structure according to a sixth aspect.

FIG. 11    is a view similar to figure 3 illustrating a heat transfer structure according to a seventh aspect.

FIG. 12    is a side view of a part of the heat transfer structure of figure 11.

FIG. 13    is a top view along arrow XIII on figure 12.

FIG. 14    is a view similar to figure 11 illustrating a heat transfer structure according to an eighth aspect.

FIG. 15    is a side view of a part of the heat transfer structure of figure 14.

FIG. 16    is a schematic perspective view, along arrow XVI on figure 15, of the part of the heat transfer structure of figure 15. Figures 1-10 do not form part of the present invention.

DETAILED DESCRIPTION OF EMBODIMENTS

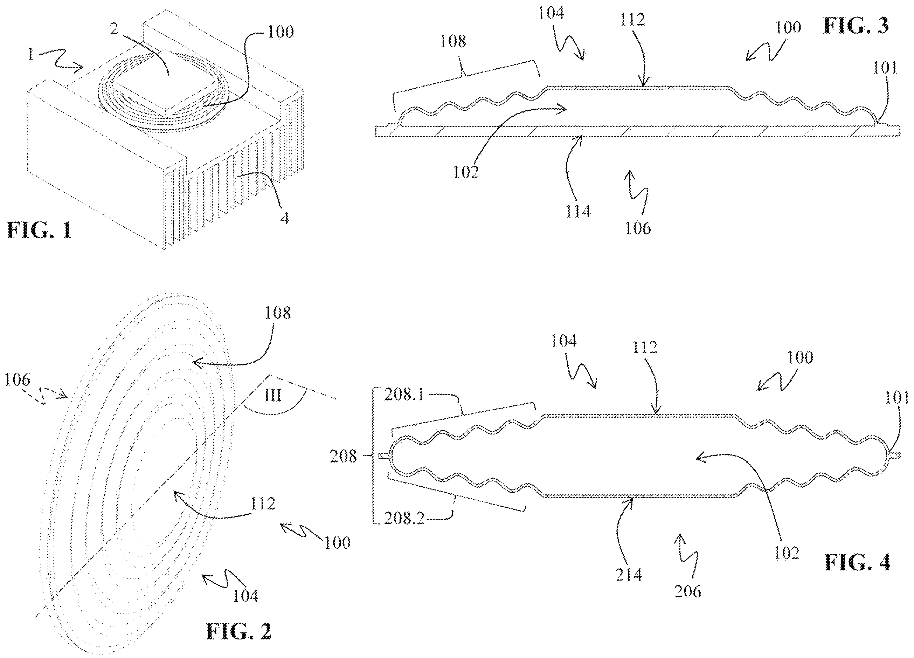

FIG. 1 shows an electronic assembly 1 according to an embodiment of the invention and comprising an electronic device 2. a heat sink 4, and a heat transfer structure 100 according to a first aspect of the invention, for transferring heat generated by electronic device 2 to heat sink 4. Heat transfer structure 100 is in thermal contact with electronic device 2 on the one side and with heat sink 4 on the other side.

FIG. 2 and 3 show heat transfer structure 100, which comprises a housing 101 defining a chamber 102 and containing an evaporative liquid (not illustrated). Housing 101 may define chamber 102 so as to hermetically contain a predetermined quantity of evaporative liquid.

Flousing 101 comprises a first part 104, a second part 106 and a circumferential part 108. First part 104 provides a heat-receiving outer surface 112 for being thermally connected to electronic device 2. Second part 106 provides a heat-emitting outer surface 114 for being thermally connected to heat sink 4. Heat-receiving outer surface 112 and heat-emitting outer surface 114 may be made of materials having a relatively large heat conductivity. Further, first part 104 and second part 106 are designed with proper material properties and thicknesses so as to avoid warpage or sagging.

In FIG. 1 heat-receiving outer surface 112 may be in thermal contact with electronic device 2, and heat-emitting outer surface 114 may be in thermal contact with heat sink 4. Heat-receiving outer surface 112 is thus located on an evaporation side of housing 101, while heat-emitting outer surface 114 is located on a condensation side of housing 101.

Heat-receiving outer surface 112 may be flat and may have the shape of a disc. Heat-emitting outer surface 114 may be flat and may have the shape of a disc. Heat-emitting outer surface 114 may have a larger area than heat-receiving outer surface 112. Heat-emitting outer surface 114 may be made of a metal plate. The plate forming heat-emitting outer surface 114 may cover both the circumferential part 108 and the heat-emitting outer surface 114. The respective sizes of heat-receiving outer surface 112 and of heat-emitting outer surface 114 may be selected according to the size of the heat source, in order to maximize the contact area.

Heat-receiving outer surface 112 and heat-emitting outer surface 114 may be parallel to each other. The metal plate part of second part 106 may be soldered or welded to the corrugated membrane part of first part 104. The thickness of the metal plate may be selected to stand a low vacuum pressure as well as a high vapor pressure inside housing 101, depending on the state of the heat transfer structure 100.

Circumferential part 108 is arranged between first part 104 and second part 106. In the example of FIG. 2 and 3 circumferential part 108 is elastically deformable to allow for a displacement of heat-emitting outer surface 114 relative to heat-receiving outer surface 112. The displacement may be caused by external forces applied on housing 101 and/or by inner forces due to the vapor pressure inside housing 101. Circumferential part 108 may be made of a material having a relatively large yield strength limit in order to enhance elastic deformation.

Circumferential part 108 may extend around heat-emitting outer surface 114 or on the circumference of heat-emitting outer surface 114. Circumferential part 108 may have an annular shape. This annular shape may be centered on a specific point of heat-emitting outer surface 114, for example on a center thereof.

Circumferential part 108 may include a corrugated membrane that is elastically deformable. Corrugations of the corrugated membrane may have the shape of sine waves in cross-section. In the example of FIG.3 circumferential part 108 includes four sine wave periods.

As visible on FIG. 3, no structural element is arranged inside housing 101. In particular, no structural element bridges first part 112 and second part 114. The gap between first part 112 and second part 114 is not spanned by any structural element. The space extending between first part 112 and second part 114 may be filled by only the evaporative liquid.

FIG. 4 illustrates a heat transfer structure 100 according to a second aspect of the invention. Inasmuch as heat transfer structure 100 of FIG. 4 is similar to heat transfer structure 100 of FIG. 2 and 3, the afore-detailed description may be applied to heat transfer structure 100 of FIG. 4, except for the hereinafter-mentioned noticeable differences. An element of heat transfer structure 100 of FIG. 4 having a structure or function identical or similar to an element of heat transfer structure 100 of FIG. 2 and 3 is given the same reference sign.

Heat transfer structure 100 of FIG. 4 differs from heat transfer structure 100 of FIG. 2 and 3 in that second part 206 has a shape symmetrical to first part 104, instead of the shape of an extended plate. In FIG.4 heat transfer structure 100 may thus present a larger deformation, hence a larger compressibility, than heat transfer structure 100 of FIG. 2 and 3.

Further, heat transfer structure 100 of FIG. 4 differs from heat transfer structure 100 of FIG. 2 and 3 in that the circumferential part 208 includes a first deformable portion 208.1 and a second deformable portion 208.2, instead of only one deformable portion in FIG. 2 and 3. First deformable portion 208.1 may extend around a heat-receiving outer surface 212, which is provided by first part 104. Second deformable portion 208.2 may extend around a flat heat-emitting outer surface 214, which is provided by second part 206. The area of heat-receiving outer surface 112 may be larger than, smaller than or equal to the area of heat-emitting outer surface 114.

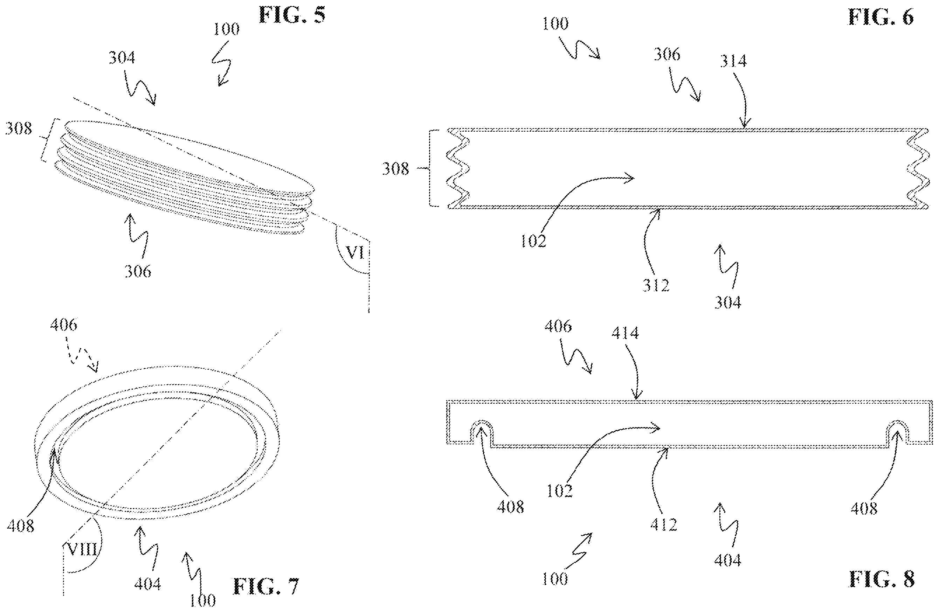

FIG. 5 and 6 illustrate a heat transfer structure 100 according to a third aspect of the invention. Inasmuch as heat transfer structure 100 of FIG. 5 and 6 is similar to heat transfer structure 100 of FIG. 2 and 3, the afore-detailed description may be applied to heat transfer structure 100 of FIG. 5 and 6, except for the hereinafter-mentioned noticeable differences. An element of heat transfer structure 100 of FIG. 5 and 6 having a structure or function identical or similar to an element of heat transfer structure 100 of FIG. 2 and 3 is given the same reference sign.

Heat transfer structure 100 of FIG. 5 and 6 differs from heat transfer structure 100 of FIG. 2 and 3 in that the circumferential part 308 includes a bellow-shaped membrane, instead of a corrugated membrane.

Further, heat transfer structure 100 of FIG. 5 and 6 differs from heat transfer structure 100 of FIG. 2 and 3 in that circumferential part 308 has a cylindrical shape, instead of an annular shape.

Besides, heat transfer structure 100 of FIG. 5 and 6 differs from heat transfer structure 100 of FIG. 2 and 3 in that second part 306 has a shape symmetrical to first part 304, hence the shape of an extended plate. First part 304 provides a large heat-receiving outer surface 312 and second part 306 provides a large heat-emitting outer surface 314.

FIG. 7 and 8 illustrate a heat transfer structure 100 according to a fourth aspect of the invention. Inasmuch as heat transfer structure 100 of FIG. 7 and 8 is similar to heat transfer structure 100 of FIG. 5 and 6, the afore-detailed description may be applied to heat transfer structure 100 of FIG. 5 and 6, except for the hereinafter-mentioned noticeable differences. An element of heat transfer structure 100 of FIG. 7 and 8 having a structure or function identical or similar to an element of heat transfer structure 100 of FIG. 5 and 6 is given the same reference sign.

Heat transfer structure 100 of FIG. 7 and 8 differs from heat transfer structure 100 of FIG. 5 and 6 in that the circumferential part 408 includes a toroidal membrane. The toroidal membrane may define the shape of a half of a toroid. The toroidal membrane may be plastically deformable due to material properties and/or thickness of circumferential part 408.

Further, heat transfer structure 100 of FIG. 7 and 8 differs from heat transfer structure 100 of FIG. 5 and 6 in that the first part 404 is not symmetrical to the second part 406. Thus, the first part 404, which has the shape of a plate, is less extended than the second part 406, which also has the shape of a plate. First part 404 provides a flat heat-receiving outer surface 412 and second part 406 provides a flat heat-emitting outer surface 414.

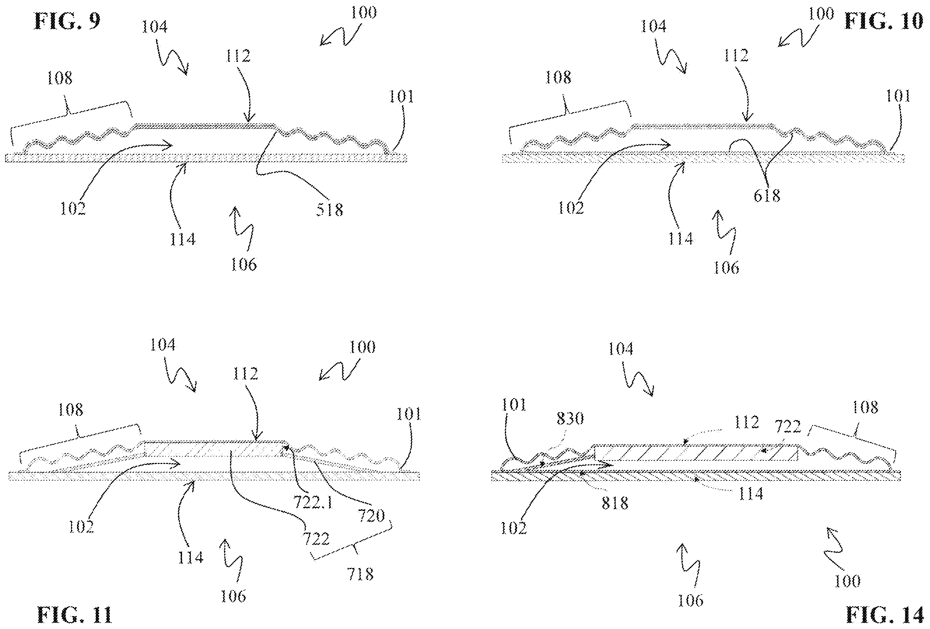

FIG. 9 illustrates a heat transfer structure 100 according to a fifth aspect of the invention. Inasmuch as heat transfer structure 100 of FIG. 9 is similar to heat transfer structure 100 of FIG. 2 and 3, the afore-detailed description may be applied to heat transfer structure 100 of FIG. 9, except for the hereinafter-mentioned noticeable differences. An element of heat transfer structure 100 of FIG. 9 having a structure or function identical or similar to an element of heat transfer structure 100 of FIG. 2 and 3 is given the same reference sign.

Heat transfer structure 100 of FIG. 9 differs from heat transfer structure 100 of FIG. 2 and 3 in that heat transfer structure 100 of FIG. 9 further comprises a porous structure 518. Porous structure 518 may be arranged within housing 101 and partly or totally in direct contact with first part 104. Porous structure 518 may be clad on first part 104. Also, porous structure 518 may be clad on circumferential part 108. Porous structure 518 forms a layer that covers first part 104 and circumferential part 108.

Porous structure 518 may be a wick structure and may be composed of a metallic material and formed by sintered metal particles, by one or more layers of mesh, or by a combination of mesh layers and sintered particles. In service porous structure 518 may enhance the efficiency of evaporation and create capillary forces to move the evaporative liquid toward heat-receiving outer surface 112. Porous structure 518 may have a thickness designed so as to promote movement of the evaporative liquid and efficient evaporation when heat transfer structure 100 is in operation. Thickness of porous structure 518 may remain constant along second part 106.

FIG. 10 illustrate a heat transfer structure 100 according to a sixth aspect. Inasmuch as heat transfer structure 100 of FIG. 10 is similar to heat transfer structure 100 of FIG. 9, the afore-detailed description may be applied to heat transfer structure 100 of FIG. 10, except for the hereinafter-mentioned noticeable differences. An element of heat transfer structure 100 of FIG. 10 having a structure or function identical or similar to an element of heat transfer structure 100 of FIG. 9 is given the same reference sign.

Heat transfer structure 100 of FIG. 10 differs from heat transfer structure 100 of FIG. 9 in that porous structure 618 of heat transfer structure 100 of FIG. 10 may be clad on, hence be in direct contact with, both first part 104 and second part 106. Porous structure 618 may be clad on first part 104. Also, porous structure 618 may be clad on circumferential part 108. Porous structure 618 forms a layer that covers first part 104, second part 106 and circumferential part 108.

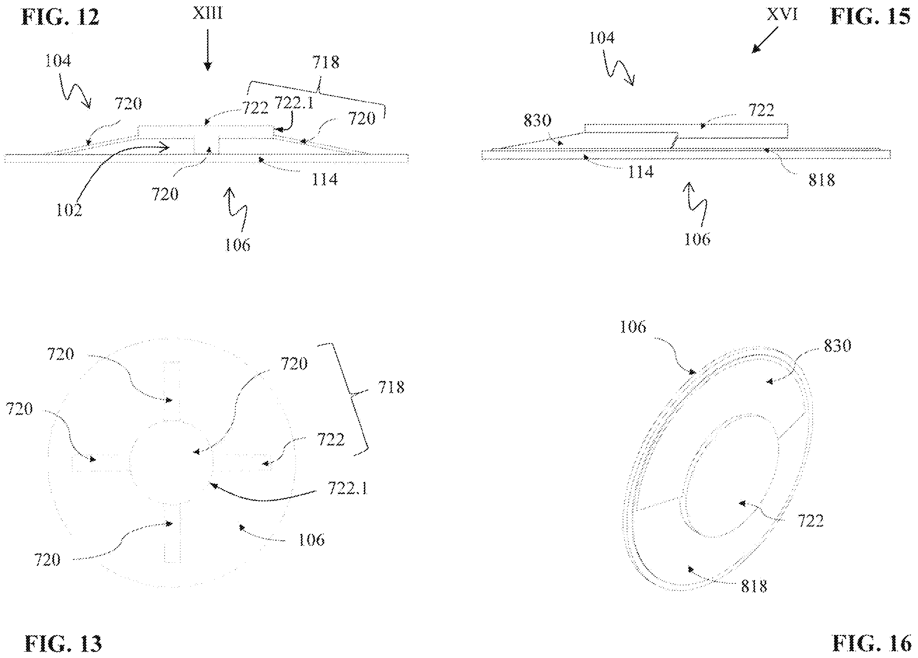

FIG. 11 to 13 illustrate a heat transfer structure 100 according to a seventh aspect of the invention. Inasmuch as heat transfer structure 100 of FIG. 11 to 13 is similar to heat transfer structure 100 of FIG. 9, the afore-detailed description may be applied to heat transfer structure 100 of FIG. 11 to 13, except for the hereinafter-mentioned noticeable differences. An element of heat transfer structure 100 of FIG. 11 to 13 having a structure or function identical or similar to an element of heat transfer structure 100 of FIG. 9 is given the same reference sign. The housing 101 is shown in FIG. 11 but not in FIG. 12 and 13.

Heat transfer structure 100 of FIG. 11 to 13 differs from heat transfer structure 100 of FIG. 9 in that: i) Porous structure 718 of heat transfer structure 100 of FIG. 11 to 13 comprises a porous deformable part 720 which extends between first part 104 and second part 106. ii) Porous structure 718 may comprise a porous rigid part 722 which may extend in contact with heat-receiving outer surface 112.

Porous rigid part 722 is attached to porous deformable part 720. Porous deformable part 720 may be formed by at least one, e.g. four, flexible arm, which extends from porous rigid part 722 to heat-emitting outer surface 114 and which may be arranged around heat-receiving outer surface 112, for example in a uniform distribution thus forming a petal-type wick structure.

The flexible arms forming porous deformable part 720 may extend obliquely to heat-receiving outer surface 112. Porous rigid part 722 may have the shape of a disc or of a relatively thin cylinder. Each flexible arm of porous deformable part 720 may have a rectangular or a triangular shape. Each flexible arm may be composed of a metallic material and formed by elements selected in the group consisting of: sintered particles, one or more layers of mesh, a single-layer of metal mesh, several layers of metal mesh, a single fiber braided metal threads, several fibers of braided metal threads, a single layer of metal felt, several layers of metal felt, and any combination thereof.

Porous deformable part 722 may be a wick configured to create capillary forces so as to absorb condensed evaporative liquid at the condensation side of housing 101, and to transport evaporative liquid toward the evaporation side of housing 101.

Porous structure 718 may be joined to housing 101 by laser welding. The laser welds may be located at a lateral surface 722.1 of porous rigid part 722, which is cylindrical in the example of FIG. 11 to 13. Alternatively or additionally the laser welds may be located at the upper edge and/or at the lower edge of lateral surface 722.1.

FIG. 14 to 16 illustrate a heat transfer structure 100 according to an eighth aspect of the invention. Inasmuch as heat transfer structure 100 of FIG. 14 to 16 is similar to heat transfer structure 100 of FIG. 11 to 13, the afore-detailed description may be applied to heat transfer structure 100 of FIG. 14 to 16, except for the hereinafter-mentioned noticeable differences. An element of heat transfer structure 100 of FIG. 14 to 16 having a structure or function identical or similar to an element of heat transfer structure 100 of FIG. 11 to 13 is given the same reference sign. The housing 101 is shown in FIG. 14 but not in FIG. 15 and 16.

Heat transfer structure 100 of FIG. 14 to 16 differs from heat transfer structure 100 of FIG. 11 to 13 in that, instead of flexible arms, heat transfer structure 100 of FIG. 14 to 16 comprises a flexible support 830 which extends between first part 104 and second part 106. Flexible support 830 may have the shape of a portion of ring extending partially around heat-receiving outer surface 112.

Heat transfer structure 100 of FIG. 14 to 16 differs from heat transfer structure 100 of FIG. 11 to 13 in that flexible support 830 comprises a leaf spring (not individually illustrated) and a wick body (not individually illustrated) that covers at least one side of flexible support 830. When heat transfer structure 100 is in operation housing 101 may provide an elastic deformation at circumferential part 108 and flexible support 830 may correspondingly be deformed elastically or plastically. The wick body may be composed of a metallic material and formed by elements selected in the group consisting of: sintered particles, one or more layers of mesh, a single-layer of metal mesh, several layers of metal mesh, a single fiber braided metal threads, several fibers of braided metal threads, a single layer of metal felt, several layers of metal felt, and any combination thereof.

Further, heat transfer structure 100 of FIG. 14 to 16 differs from heat transfer structure 100 of FIG. 11 to 13 in that porous structure 818 of heat transfer structure 100 of FIG. 14 to 16 is in direct contact with second part 106. Porous structure 818 may be composed of a metallic material and formed by sintered particles, by one or more layers of mesh, or by a combination of mesh layers and sintered particles.

Porous structure 818 and flexible support 830 are arranged such that the wick body of flexible support 830 is hydraulically connected to porous rigid part 722. Thus, the evaporative liquid may be transported from heat-emitting outer surface 114 to heat-receiving outer surface 112. When housing 101 is compressed or decompressed, flexible support 830 changes its angle with respect to porous rigid part 722 which is flat.

When heat transfer structure 100 of any one of FIG. 2 to 16 is in service the evaporative liquid may evaporate when heat-receiving surface 112 receives heat from the heat source, i.e. from electronic device 2. Heat generated in electronic device 2 heats up the evaporative liquid proximate heat-receiving surface 112 and causes evaporative liquid to vaporize. Evaporation of the evaporative liquid occurs on the evaporation side of housing 101.

The vapor of evaporative liquid may flow across chamber 102 and toward heat-emitting outer surface 114. The vapor of evaporative liquid may condense when heat-emitting outer surface 114 emits heat and may hence dissipate it in the ambient. The heat released from the condensation of evaporative liquid is transferred to heat sink 4. Condensation of evaporative liquid occurs on the condensation side of housing 101. The condensed evaporative liquid may flow toward heat-receiving outer surface 112 across housing 101, for example through a porous structure as the case may be. The evaporation and condensation cycle may continue in a repetitive mode.

When installing heat transfer structure 100 of any one of FIG. 2 to 16 housing 101 may be first compressed by external forces, for example during assembly of electronic device 2. and then decompressed after release of the external forces applied thereon. While decompressing housing 101 self-adjusts its height to fill the air gap remaining between heat source and heat sink. Evaporative liquid in chamber 102 may help in decompressing housing 101 due to its vapor pressure acting inside housing 101.

The actual thickness may be defined by balance between i) external forces applied on outer surfaces of the housing and ii) vapor pressure acting on inner surfaces of the housing. As vapor pressure inside the housing may vary when the heat transfer structure is in operation, the initial compression distance is set so as to avoid appearance of an air gap around the heat transfer structure in case the vapor pressure drops. Conversely, an increasing inner vapor pressure inside the housing can enhance thermal contact between the heat-receiving surface and the heat source and between the heat-emitting surface and the heat sink.

As an example, thermal performances tests were carried out on heat transfer structure 100 of FIG. 11 to 13 in order to evaluate the evaporation and condensation cycle taking place inside housing 101. The heat-receiving outer surface 112 was attached to a heat source so as to apply a heat load onto it. The heat-emitting outer surface 114 was attached to a water circulated thermal bath as the heat sink with permanent water temperature settings. The circumferential part 108 was thermally insulated from both the heat source and the heat sink. The points of temperature measurements were defined at the geometric center of the first part 104 and second part 106.

A one-dimensional thermal resistance $R_{1D}$ is defined as:

$$R_{1D} = \frac{T_{104} - T_{106}}{\text{Heat load}}$$

where:

$R_{1D}$ is the one-dimensional thermal resistance, in K/W;
$T_{104}$ is the temperature at the geometric center of first part 104, in °C or in K;
$T_{106}$ is the temperature at the geometric center of second part 106. in °C or in K;
Heat load is the heat load, in W.

The thermal performances tests yielded the following results:

| $R_{ID}$, K/W | 0.141 | 0.105 | 0.080 | 0.057 | 0.053 | 0.051 | 0.057 |
|---|---|---|---|---|---|---|---|
| Heat sink Temperature, °C | 30.0 | 40.0 | 50.0 | 60.0 | 65.0 | 70.0 | 80.0 |
| Heat load, W | 47.6 | | | | | | |

## Claims

1. A heat transfer structure (100), for transferring heat generated by an electronic device (2) to a heat sink (4), the heat transfer structure (100) comprising a housing (101) defining a chamber (102) and containing an evaporative liquid, wherein the housing (101) comprises at least:

   i) a first part (104) which provides a heat-receiving outer surface (112; 312; 412) for being thermally connected to the electronic device (2),
   ii) a second part (106) which provides a heat-emitting outer surface (114; 214; 314; 414) for being thermally connected to the heat sink (4),
   iii) a circumferential part (108; 208; 308; 408) arranged between the first part (104) and the second part (106), wherein the circumferential part (108; 208; 308; 408) is plastically or elastically deformable to allow for a displacement of the heat-emitting outer surface (114; 214; 314; 414) relative to the heat-receiving outer surface (112; 312; 412), and
   iv) a porous structure (718; 818) arranged within the housing (101) and partly or totally in direct contact with the first part (104), wherein the porous structure (718; 818) comprises a porous deformable part (720; 830) which extends between the first part (104) and the second part (106),

   **characterized in that** the porous deformable part (720) includes one or more flexible arms, least one of the one or more flexible arms being arranged around the heat-receiving outer surface (112).

2. The heat transfer structure (100) of claim 1, wherein the circumferential part (108; 208; 308) includes a corrugated or bellow-shaped membrane, the corrugated or bellow-shaped membrane being elastically deformable.

3. The heat transfer structure (100) of claim 1 or 2, wherein the circumferential part (108; 208; 308) has an annular shape or a cylindrical shape.

4. The heat transfer structure (100) of claim 1 or 3, wherein the circumferential part (308) includes a toroidal membrane, the toroidal membrane defining the shape of a half of a toroid and being plastically deformable.

5. The heat transfer structure (100) of any one of the preceding claims, wherein at least one of the heat-receiving outer surface (112; 312; 412) and the heat-emitting outer surface (114; 214; 314; 414) is flat.

6. The heat transfer structure (100) of any one of the preceding claims, wherein the circumferential part (208) includes at least one of i) a first deformable portion (208.1) extending around the heat-receiving outer surface (112) and ii) a second deformable portion (208.2) extending around the heat-emitting outer surface (214).

7. The heat transfer structure (100) of any one of the preceding claims, wherein no structural element is arranged inside the housing (101).

8. The heat transfer structure (100) of claim 1, further comprising a flexible support (830) extending i) between the first part (104) and the second part (106) and ii) partially around the heat-receiving outer surface (112).

9. The heat transfer structure (100) of claim 8, wherein at least a portion of the porous structure (718; 818) is in direct contact with the housing (101).

10. An electronic assembly comprising an electronic device (2), a heat sink (4), and a heat transfer structure (100) of any one of the preceding claims, wherein the first part (104) of the housing (101) is in thermal contact with the electronic device (2) and the second part (106) is in thermal contact with the heat sink (4).

**Patentansprüche**

1. Wärmeübertragungsstruktur (100) zum Übertragen von Wärme, die von einer elektronischen Vorrichtung (2) erzeugt wird, auf einen Kühlkörper (4), wobei die Wärmeübertragungsstruktur (100) ein Gehäuse (101) umfasst, das eine Kammer (102) definiert und eine Verdunstungsflüssigkeit enthält, wobei das Gehäuse (101) mindestens Folgendes umfasst:

i) einen ersten Teil (104), der eine wärmeaufnehmende Außenfläche (112; 312; 412) bereitstellt, um thermisch mit der elektronischen Vorrichtung (2) verbunden zu sein,
i) einen zweiten Teil (106), der eine wärmeabgebende Außenfläche (114; 214; 314; 414) bereitstellt, um thermisch mit dem Kühlkörper (4) verbunden zu sein,
iii) einen Umfangsteil (108; 208; 308; 408), der zwischen dem ersten Teil (104) und dem zweiten Teil (106) angeordnet ist, wobei der Umfangsteil (108; 208; 308; 408) plastisch oder elastisch verformbar ist, um eine Verschiebung der wärmeabgebenden Außenfläche (114; 214; 314; 414) relativ zur wärmeaufnehmenden Außenfläche (112; 312; 412) zu gestatten, und
iv) eine poröse Struktur (718; 818), die innerhalb des Gehäuses (101) und teilweise oder vollständig in direktem Kontakt mit dem ersten Teil (104) angeordnet ist, wobei die poröse Struktur (718; 818) einen porösen verformbaren Teil (720; 830) umfasst, der sich zwischen dem ersten Teil (104) und dem zweiten Teil (106) erstreckt, **dadurch gekennzeichnet, dass** der poröse verformbare Teil (720) einen oder mehrere flexible Arme aufweist, wobei mindestens einer des einen oder der mehreren flexiblen Arme um die wärmeaufnehmende Außenfläche (112) herum angeordnet ist.

2. Wärmeübertragungsstruktur (100) nach Anspruch 1, wobei der Umfangsteil (108; 208; 308) eine gewellte oder balgförmige Membran aufweist, wobei die gewellte oder balgförmige Membran elastisch verformbar ist.

3. Wärmeübertragungsstruktur (100) nach Anspruch 1 oder 2, wobei der Umfangsteil (108; 208; 308) eine Ringform oder eine Zylinderform aufweist.

4. Wärmeübertragungsstruktur (100) nach Anspruch 1 oder 3, wobei der Umfangsteil (308) eine toroidale Membran aufweist, wobei die toroidale Membran die Form einer Hälfte eines Toroids definiert und plastisch verformbar ist.

5. Wärmeübertragungsstruktur (100) nach einem der vorhergehenden Ansprüche, wobei mindestens eine von der wärmeaufnehmenden Außenfläche (112; 312; 412) und der wärmeabgebenden Außenfläche (114; 214; 314; 414) flach ist.

6. Wärmeübertragungsstruktur (100) nach einem der vorhergehenden Ansprüche, wobei der Umfangsteil (208) mindestens eines von i) einem ersten verformbaren Abschnitt (208.1), der sich um die wärmeaufnehmende Außenfläche (112) herum erstreckt, und ii) einem zweiten verformbaren Abschnitt (208.2) umfasst, der sich um die wärmeabgebende Außenfläche (214) herum erstreckt.

7. Wärmeübertragungsstruktur (100) nach einem der vorhergehenden Ansprüche, wobei kein Strukturelement innerhalb des Gehäuses (101) angeordnet ist.

8. Wärmeübertragungsstruktur (100) nach Anspruch 1, ferner umfassend eine flexible Stütze (830), die sich i) zwischen dem ersten Teil (104) und dem zweiten Teil (106) und ii) teilweise um die wärmeaufnehmende Außenfläche (112) herum erstreckt.

9. Wärmeübertragungsstruktur (100) nach Anspruch 8, wobei mindestens ein Abschnitt der porösen Struktur (718; 818) in direktem Kontakt mit dem Gehäuse (101) steht.

10. Elektronische Anordnung, umfassend eine elektronische Vorrichtung (2), einen Kühlkörper (4) und eine Wärmeübertragungsstruktur (100) nach einem der vorhergehenden Ansprüche, wobei der erste Teil (104) des Gehäuses (101) in thermischem Kontakt mit der elektronischen Vorrichtung (2) steht und der zweite Teil (106) in thermischem Kontakt mit dem Kühlkörper (4) steht.

## Revendications

1. Structure de transfert de chaleur (100), destinée à transférer la chaleur générée par un dispositif électronique (2) vers un dissipateur thermique (4), la structure de transfert de chaleur (100) comprenant un boîtier (101) définissant une chambre (102) et contenant un liquide évaporatif, dans laquelle le boîtier (101) comprend au moins :

   i) une première partie (104) qui fournit une surface extérieure réceptrice de chaleur (112 ; 312 ; 412) destinée à être connectée thermiquement au dispositif électronique (2),
   ii) une seconde partie (106) qui fournit une surface extérieure émettrice de chaleur (114; 214 ; 314 ; 414) destinée à être thermiquement connectée au dissipateur thermique (4),
   iii) une partie circonférentielle (108 ; 208 ; 308 ; 408) disposée entre la première partie (104) et la seconde partie (106), dans laquelle la partie circonférentielle (108 ; 208 ; 308 ; 408) est plastiquement ou élastiquement déformable pour permettre un déplacement de la surface extérieure émettrice de chaleur (114 ; 214 ; 314 ; 414) par rapport à la surface extérieure réceptrice de chaleur (112 ; 312 ; 412), et
   iv) une structure poreuse (718 ; 818) disposée à l'intérieur du boîtier (101) et partiellement ou totalement en contact direct avec la première partie (104), dans laquelle la structure poreuse (718 ; 818) comprend une partie poreuse déformable (720 ; 830) qui s'étend entre la première partie (104) et la seconde partie (106), **caractérisée en ce que** la partie poreuse déformable (720) comprend un ou plusieurs bras flexibles, au moins un des un ou plusieurs bras flexibles étant disposé autour de la surface extérieure réceptrice de chaleur (112).

2. Structure de transfert de chaleur (100) selon la revendication 1, dans laquelle la partie circonférentielle (108 ; 208 ; 308) comprend une membrane ondulée ou en forme de soufflet, la membrane ondulée ou en forme de soufflet étant élastiquement déformable.

3. Structure de transfert de chaleur (100) selon la revendication 1 ou 2, dans laquelle la partie circonférentielle (108 ; 208 ; 308) a une forme annulaire ou cylindrique.

4. Structure de transfert de chaleur (100) selon la revendication 1 ou 3, dans laquelle la partie circonférentielle (308) comprend une membrane toroïdale, la membrane toroïdale définissant la forme d'une moitié de toroïde et étant plastiquement déformable.

5. Structure de transfert de chaleur (100) selon l'une quelconque des revendications précédentes, dans laquelle au moins une de la surface extérieure réceptrice de chaleur (112 ; 312 ; 412) et de la surface extérieure émettrice de chaleur (114 ; 214 ; 314 ; 414) est plate.

**6.** Structure de transfert de chaleur (100) selon l'une quelconque des revendications précédentes, dans laquelle la partie circonférentielle (208) comprend au moins une i) d'une première partie déformable (208.1) s'étendant autour de la surface extérieure réceptrice de chaleur (112) et ii) d'une seconde partie déformable (208.2) s'étendant autour de la surface extérieure émettrice de chaleur (214).

**7.** Structure de transfert de chaleur (100) selon l'une quelconque des revendications précédentes, dans laquelle aucun élément structurel n'est disposé à l'intérieur du boîtier (101).

**8.** Structure de transfert de chaleur (100) selon la revendication 1, comprenant en outre un support flexible (830) s'étendant i) entre la première partie (104) et la seconde partie (106) et ii) partiellement autour de la surface extérieure réceptrice de chaleur (112).

**9.** Structure de transfert de chaleur (100) selon la revendication 8, dans laquelle au moins une partie de la structure poreuse (718 ; 818) est en contact direct avec le boîtier (101).

**10.** Ensemble électronique comprenant un dispositif électronique (2), un dissipateur thermique (4) et une structure de transfert de chaleur (100) selon l'une quelconque des revendications précédentes, dans lequel la première partie (104) du boîtier (101) est en contact thermique avec le dispositif électronique (2) et la seconde partie (106) est en contact thermique avec le dissipateur thermique (4).

FIG. 1

FIG. 2

FIG. 3

FIG. 4

FIG. 5

FIG. 6

FIG. 7

FIG. 8

EP 3 948 945 B1

14

FIG. 9

FIG. 10

FIG. 11

FIG. 14

FIG. 12

FIG. 15

FIG. 13

FIG. 16

EP 3 948 945 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040052052 A1
- US 20080053640 A1
- US 20070146996 A1
- US 20170038154 A1